**Europäisches Patentamt**

(19) **European Patent Office**

**Office européen des brevets**

(11) Numéro de publication: **0 061 950**
**B1**

(12) **FASCICULE DE BREVET EUROPEEN**

(45) Date de publication du fascicule du brevet:
13.02.85

(51) Int. Cl.⁴: **H 03 H 7/075, H 04 B 3/14**

(21) Numéro de dépôt: **82400418.8**

(22) Date de dépôt: **09.03.82**

(54) Filtres électriques autocorrigés d'ordre impair.

(30) Priorité: **20.03.81 FR 8105658**

(43) Date de publication de la demande:
**06.10.82 Bulletin 82/40**

(45) Mention de la délivrance du brevet:
**13.02.85 Bulletin 85/7**

(84) Etats contractants désignés:
**BE DE GB IT NL SE**

(56) Documents cités:
**EP - A - 0 057 112**
**FR - A - 1 471 194**

**ELECTRONIC INDUSTRIES, vol. 23, no. 1, janvier 1964 PHILADELPHIA (US) E.C. JOHNSON: "New developments in... designing bandpass filters" pages 87-94**
**IEEE TRASNACTIONS ON CIRCUITS AND SYSTEMS, vol. CAS-24, no. 5, mai 1977 NEW YORK (US) M. ORSUCCI et al.: "On the synthesis of bandpass filters with bridged topology" pages 252-260**
**IEEE TRANSACTIONS ON MICROWAVE THEORY AND TECHNIQUES, vol. MTT-20, no. 4, avril 1972 NEW YORK (US) ALI E. ATIA: "Narrow bandpass waveguide filters" pages 258-265**

(73) Titulaire: **THOMSON-CSF, 173, Boulevard Haussmann, F-75379 Paris Cedex 08 (FR)**

(72) Inventeur: **Darmouni, Corinne, THOMSON-CSF SCPI 173, bld Haussmann, F-75360 Paris Cedex 08 (FR)**

(74) Mandataire: **Lincot, Georges et al, THOMSON-CSF SCPI 173, Bld Haussmann, F-75379 Paris Cedex 08 (FR)**

**Description**

La présente invention se rapporte, aux filtres électriques autocorrigés d'ordre impair, à éléments à constantes localisées, du type passe bande, qui permettent de filtrer les signaux analogiques ou numériques dans cette bande de fréquence et qui permettent de corriger la distorsion du temps de propagation de groupe et/ou de corriger l'amplitude dans cette bande de fréquence.

De tels filtres sont particulièrement utiles dans les récepteurs de faisceaux hertziens. Dans une réalisation particulière de tels récepteurs on utilise des filtres électriques classiques. Les filtres classiques ne corrigent pas la distorsion du temps de propagation de groupe et/ou l'amplitude. Or très souvent, il apparait un inconvénient gênant pour la transmission du signal. Le temps de passage aux différentes fréquences de la bande passante n'est pas constant. En effet, le temps de propagation de groupe croit depuis une valeur faible pour les fréquences centrales de la bande passante jusqu'à une valeur élevée pour les fréquences limites de la bande passante. La fonction de correction du temps de propagation de groupe est réalisée par des réseaux correcteurs. Ces réseaux sont très souvent constitués par une ou plusieurs cellules comportant des éléments actifs. Lorsqu'il y a plusieurs cellules dans le réseau correcteur, chaque cellule est isolée des cellules adjacentes, par un transistor. Ces réseaux correcteurs sont mis en cascade à la suite du filtre. Pour un récepteur de faisceaux hertziens, il est courant d'utiliser deux cellules en cascade pour la correction de temps de propagation de groupe. Les fréquences centrales des deux cellules sont situées de part et d'autre de la fréquence centrale du filtre passe-bande que l'on cherche à compenser. Cependant l'amplitude reste liée à la correction du temps de propagation de groupe et ces réseaux correcteurs présentent également les inconvénients d'être très encombrants, de présenter une fiabilité insuffisante et de nécessiter l'emploi d'alimentations particulieres pour les cellules actives.

Dans certaines applications en hyperfréquence, on utilise des filtres micro-onde à bande passante étroite. La fonction de correction du temps de propagation de groupe est réalisée en utilisant des cavités multiples couplées. La synthèse de ces filtres a été exposée dans la littérature technique comme le montrent les publications suivantes: J. D. Rhodes »filtre généralisé à phase linéaire par cavité à couplage direct« IEEE Transactions MTT, Volume MTT 18, N° 6, juin 1970, pages 308—313; A. E. Atia et autres »filtres guides d'ondes à bande étroite« IEEE Transactions MTT, Volume MTT 18, N° 4, avril 1972, pages 258—264; A. E. Atia et autres »Synthèse des cavités multiples couplées à bande étroite« IEEE Transactions CAS, Volume CAS-21, N° 5, septembre 1974, pages 649—655.

Cependant aucun de ces articles ne traite des modèles constitués par un nombre impair de résonateurs et les réalisations décrites ne sont pas exploitables en basse fréquence ou en fréquence intermédiaire pour des raisons évidentes de dimensionnement et d'encombrement trop important, des filtres guides d'onde à bande étroite et à cavités multiples couplées qu'il faudrait réaliser.

Des travaux d'étude sur des filtres basse fréquence à éléments discrets composés d'inductances et de condensateurs, ayant une topologie en pont et une caractéristique de Tchebyshev dans la bande d'utilisation du filtre et une réponse hors bande déterminée sont décrits dans la publication de MM. Orsucci, Reggiani et Stacchiotti ayant pour titre »On the Synthesis of Bandpass Filters with Bridged Topology« publiée dans IEEE Transactions on circuits and systems, Vol. cas-24, n° 5, May 1977, pages 252—260, mais cet article ne traite que des problèmes liés à la correction d'amplitude, sans résoudre les problèmes liés à la correction du temps de propagation de groupe.

L'invention a pour but de pallier les difficultés précitées.

A cet effet, l'invention a pour objet, un filtre électrique autocorrigé d'ordre impair à éléments à constantes localisées, comportant des premiers moyens d'adaptation d'entrée pour recevoir le signal d'entrée, l'adapter et le transmettre à des moyens de filtrage constitués par un ensemble de n résonateurs en nombre impair et en cascade pour filtrer le signal en large bande et le transmettre à des deuxièmes moyens d'adaptation de sortie, et comportant des moyens de corrections constitués par un premier ensemble de moyens de couplage adjacent Mi,j; chaque moyen Mi,j reliant deux résonateurs adjacents i et j, i étant égal à 1, 2 ... (n—1), j étant égal à i + 1, caractérisé en ce que les moyens de corrections comprennent également un deuxième ensemble de moyens de couplage non adjacent Mk,l, chaque moyen reliant un $k^{ième}$ et un $l^{ième}$ résonateur, k étant égal à 1, 2, 3 ... (n—3) et l étant égal à k+3, pour obtenir une symétrie arithmétique des courbes d'amplitude et de temps de propagation de groupe, et corriger les distorsions du temps de propagation de groupe.

D'autres particularités et avantages de l'invention apparaitront clairement dans la description suivante présentée à titre d'exemple non limitatif en regard des figures annexées suivantes:

— la figure 1 représente le schéma de principe du filtre électrique autocorrigé d'ordre impair;

— la figure 2 représente une première réalisation particulière du filtre selon l'invention;

— la figure 3 représente les courbes d'amplitude et de temps de propagation de groupe pour une bande de fréquence donnée, selon la première réalisation du filtre;

— la figure 4 représente un premier mode de branchement pour un résonateur;

— la figure 5 représente un deuxième mode de branchement pour un résonateur;

— la figure 6 représente une deuxième réalisation du filtre selon l'invention;

— la figure 7 représente une troisième réalisation du filtre selon l'invention;

— la figure 8 représente les courbes d'amplitude et de temps de propagation de groupe selon la deuxième et le troisième réalisation.

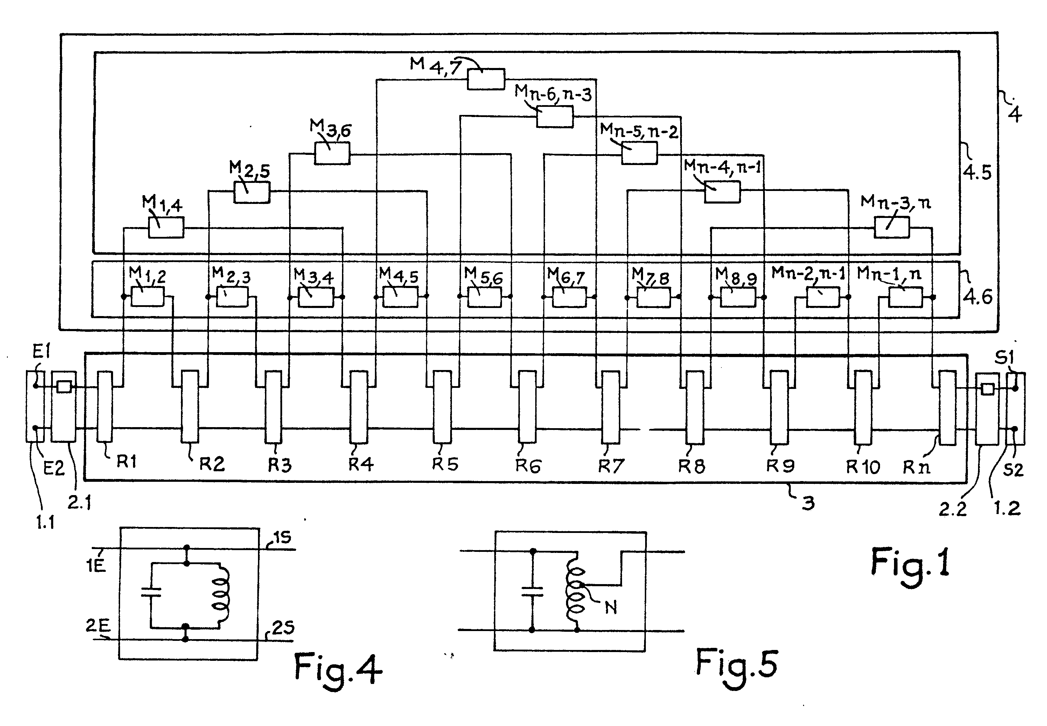

Le filtre électrique autocorrigé d'ordre impair selon l'invention, dont le schéma de principe est représenté sur la figure 1, reçoit le signal d'entrée par une première paire de bornes d'accès E1, E2. Cette première paire de bornes d'accès constitue l'entrée du filtre. Un adaptateur d'impédance d'entrée 2.1 reçoit ce signal pour l'adapter et le transmettre aux moyens de filtrages. L'adaptateur d'impédance d'entrée 2.1 comporte 2 entrées et 2 sorties. Les deux sorties sont connectées aux entrées des moyens de filtrages 3. Ces moyens comprennent deux entrées, deux sorties, et sont constitués par un nombre n de résonateurs $(R_1, \ldots R_n)$; n étant un nombre entier, impair. Sur le schéma de principe on s'est limité à n égal à 11. Chaque résonateur comporte une première et une deuxième entrée, une première et une deuxième sortie. Les sorties d'un premier résonateur sont branchées directement ou indirectement aux entrées d'un deuxième résonateur. Ce branchement est qualifié de branchement en cascade. Les 2 sorties des moyens de filtrage 3, sont connectées à un adaptateur d'impédance de sortie 2.2. Les deux sorties des moyens de filtrage 3 sont les deux sorties du dernier résonateur. Les deux sorties de l'adaptateur d'impédance de sortie 2.2 sont connectées aux deuxièmes bornes d'accès du filtre S1 et S2. Ces deux bornes constituent les sorties du filtre. Les moyens d'autocorrection 4 de temps de propagation de groupe et/ou d'amplitude comportent un ensemble de moyens de couplages adjacents 4.6, et un ensemble de moyens de couplages non adjacents 4.5. Les moyens d'autocorrection 4 sont connectés aux moyens de filtrage 3 par l'intermédiaire de couplages adjacents 4.6. Les couplages adjacents sont constitués par des éléments à constantes localisées Mi,j. Chaque résonateur possède une sortie reliée à une entrée du résonateur adjacent par l'intermédiaire d'un couplage adjacent Mi,j.

Mi,j est tel que

$$i = 1, 2 \ldots, n-1$$
$$j = i+1$$

Il représente le couplage entre le $i^{ème}$ résonateur et le $j^{ème}$; le $j^{ème}$ étant le suivant. Les moyens d'autocorrection 4 comportent également des couplages non adjacents 4.5. Les couplages non adjacents sont constitués par des éléments à constantes localisées Mk,l. Ces couplages non adjacents sont connectés entre la première sortie du $k^{ème}$ résonateur et la première entrée du $l^{ème}$ résonateur avec k pouvant être égal à 1, 2, 3 … (n—3) l étant égal à k+3. Pour n=11 on a les couplages suivants:

M1,4 entre le $1^{er}$ et le $4^{ième}$ résonateur
M2,5 entre le $2^{ième}$ et le $5^{ième}$
M3,6 entre le $3^{ième}$ et le $6^{ième}$
M4,7 entre le $4^{ième}$ et le $7^{ième}$
M5,8 entre le $5^{ième}$ et le $8^{ième}$
M6,9 entre le $6^{ième}$ et le $9^{ième}$
M7,10 entre le $7^{ième}$ et le $10^{ième}$
M8,11 entre le $8^{ième}$ et le $11^{ième}$

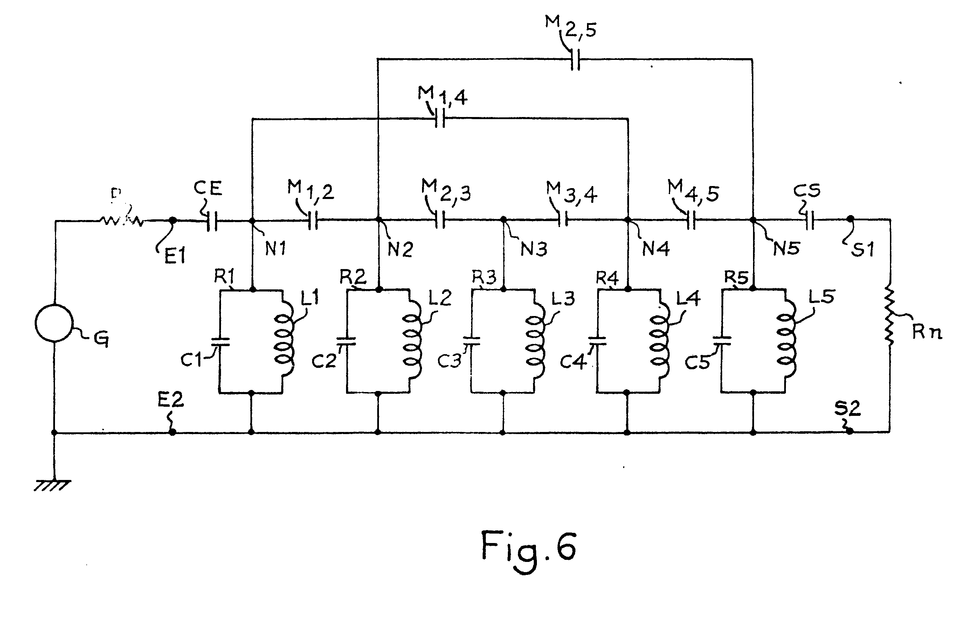

Les figures 4 et 5 représentent le schéma électrique des résonateurs.

La figure 4 représente un premier mode de branchement d'un couplage non adjacent sur une première sortie d'un résonateur.

La figure 5 représente un deuxième mode de branchement. Les deux résonateurs représentés en figure 4 et 5 sont identiques dans leur constitution. Ils comportent classiquement un condensateur en parallèle sur une inductance (et éventuellement une résistance en parallèle sur l'inductance ou sur le condensateur pour amortir le résonateur) ayant des valeurs déterminées pour résonner à la fréquence d'accord. Les résonateurs sont munis de deux entrées et de deux sorties.

Sur la figure 4 le résonateur possède une première entrée et une première sortie qui sont soumises à une même premier potentiel. La deuxième entrée et la deuxième sortie sont soumises à un même deuxième potentiel. Le couplage adjacent correspondant à ce résonateur est branché à la première sortie.

La figure 5 diffère de la figure 4 en un point. La première sortie est dans ce cas prise en un point milieu N de l'inductance. Le couplage non adjacent est connecté en ce point N.

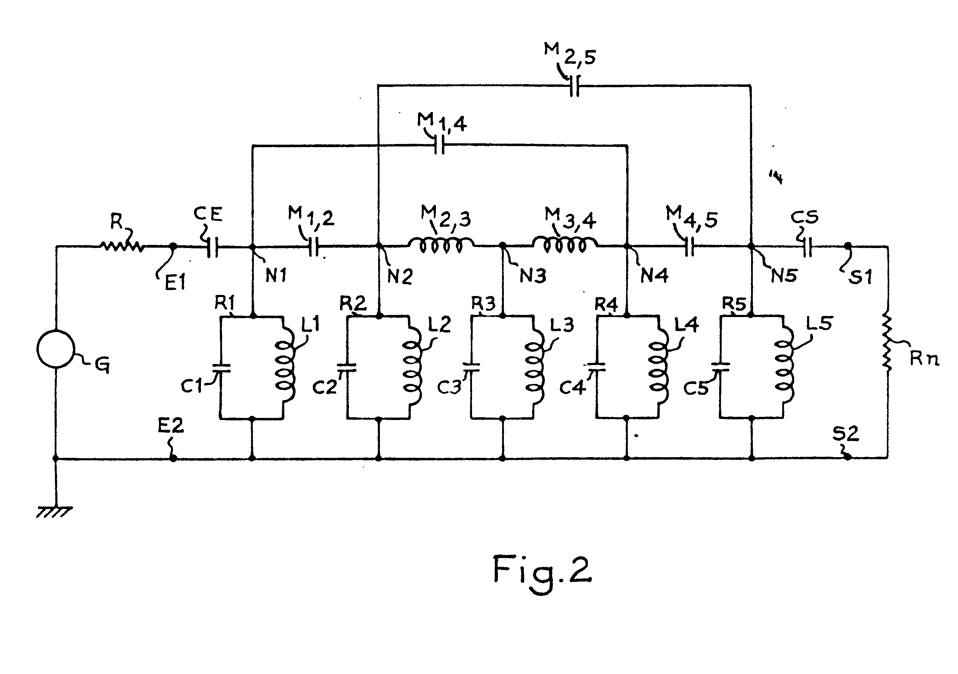

La figure 2 représente une réalisation particulière du filtre selon l'invention. Le filtre est réalisé pour une fréquence centrale qui se situe dans le domaine des fréquences intermédiaires aux alentours de 70 MHz. La bande passante à 3 dB est dans cette réalisation particulière de 1,25 MHz.

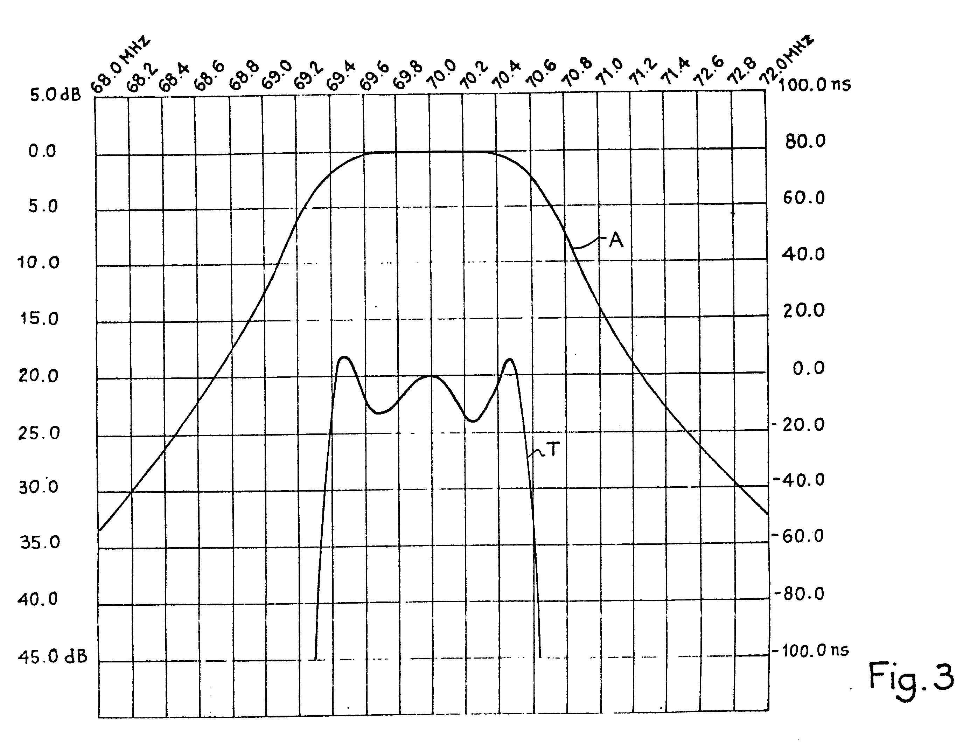

En se référant au schéma de principe de la figure 1, et en prenant le mode de réalisation représenté sur la figure 2, nous obtenons un filtre ayant les caractéristiques de l'invention. La correction de temps de propagation de groupe se traduit physiquement par une amélioration de la transmission du signal. Cette correction peut également s'observer sur l'allure de la courbe de temps de propagation qui est représentée sur la figure 3.

La description suivante se référe donc au schéma de principe de la figure 1, et au schéma de réalisation de la figure 2. Le filtre est alimenté par un mélangeur de récepteur représenté sur le schéma par un générateur G, fournissant un signal de fréquence 70 MHz, et d'amplitude Vo. L'impédance interne R du générateur G est de 75 Ω. Le signal délivré par le générateur est appliqué à l'entrée du filtre entre les bornes d'accès E1 et E2. La deuxième entrée E2 du filtre est au potentiel O. Les adaptateurs d'impédance 2.1 et 2.2 sont des condensateurs CE et CS. Le condensateur CE est connecté entre l'entrée E1 et la première entrée du premier résonateur R1. Le condensateur CS est en série entre la sortie S1 et le dernier résonateur R5. Les deux condensateurs sont égaux à 5,18 pF dans cet exemple particulier, compte tenu des moyens de génération du signal. Les moyens de filtrage 3 sont constitués par 5 résonateurs R1, R2 ... R5. Chaque résonateur est identique à celui qui est représenté sur la figure 4. La première entrée 1E, et la première sortie 1S des résonateurs sont au même potentiel. Ce même potentiel constitue pour chaque résonateur, un nœud N1, N2 ... N5. Les deuxièmes entrées et deuxièmes sorties sont au potentiel 0. Chaque résonateur est connecté au suivant, par l'intermédiaire des couplages adjacents. Les couplages adjacents M1,2 et M4,5 connectés respectivement entre le premier et le deuxième, le quatrième et le cinquième résonateur sont des éléments capacitifs. Les couplages adjacents M2,3 et M3,4 connectés respectivement entre le deuxième et le troisième, le troisième et le quatrième, sont des éléments auto-inductifs. Le couplage non-adjacent M1,4 entre le premier et le quatrième résonateur est capacitif. Le couplage non adjacent entre le deuxième et le cinquième résonateur est capacitif. Naturellement, il est clair que chaque inductance peut être remplacée par un élément équivalent, soit une inductance bien déterminée en série avec un condensateur également bien déterminé, soit une inductance en parallèle sur un condensateur, soit trois inductances connectée en forme de »T«, c'est-à-dire une première inductance en série avec une deuxième et une troisième connectée entre le point commun des deux premières et le potentiel S2. Les valeurs des couplages adjacents ou non adjacents sont déterminées à partir de la méthode de synthèse des filtres. Cette méthode de synthèse consiste à trouver la matrice de couplage et les coefficients d'adaptation pour obtenir une fonction de transfert du filtre demandée. Elle est connue pour des bandes passantes étroites. Les résultats obtenus ne sont pas, par conséquents optimisés. Les calculs des éléments auto-inductifs et capacitifs sont réalisés à partir des équations suivantes:

$$\begin{cases} L_{ij} = \dfrac{R \cdot Rn}{2\,\pi\,fo\,M_{ij}} \\ \\ C_{ij} = \dfrac{M_{ij}}{2\,\pi\,fo\,R \cdot Rn} \end{cases}$$

On calcule les éléments auto-inductifs et capacitifs des résonateurs à l'aide des équations suivantes:

$$\begin{cases} L = \dfrac{R \cdot Rn}{2\,\pi\,fo}\left(\dfrac{fp}{fo} - \dfrac{fo}{fp}\right) \\ \\ C = \dfrac{1}{4\,\pi^2\,fo^2\,L} \end{cases}$$

fo est la fréquence centrale du filtre, fp la fréquence supérieure de la dernière ondulation.

R est la résistance interne du générateur, Rn est la résistance de la charge.

Mi,j est le terme d'ordre i,j de la matrice M de couplage.

On obtient un premier ensemble de résultats à partir de ces équations. On utilise la méthode d'optimisation de K. Madsen, H. Schiaer-Jacobsen, J. Volcby exposee dans la littérature technique, »Automated Minimax Design of NET works«, IEEE — cir. and Syst., volume CAS-22; n° 10, octobre 1975, pages 791—795. Cette méthode d'optimisation permet de diminuer les écarts entre la réponse idéale du filtre H(Fj) et la réponse réelle $H_0$(Fj) pour une fréquence donnée Fj. Pour mesurer la qualité de la réponse réelle et guider l'optimisation afin d'améliorer la qualité, deux critères sont envisagés. D'une part on considère soit l'écart quadratique moyens de m fonction H(Fj)

$$Eq = \sqrt{\frac{1}{m}\sum_{j=1}^{m} H(Fj) - H_0(Fj)^2}$$

soit l'écart maximum de m fonctions H(Fj)

$$E_{max} = \max_j (H(Fj) - H_0(Fj)).$$

La méthode d'optimisation tient compte des pertes sur chaque élément. Cette méthode suppose donc que chaque élément n'est pas parfait car il présente des caractéristiques résistives à la fréquence de résonance. Une inductance Lo est équivalente à une inductance L en série avec une résistance R égale à $L\,2\,fo\,\pi/Q1$ où Q1 est le coefficient de surtension de l'inductance L. R représente les pertes un condensateur Co est équivalent à un condensateur C en parallèle sur une résistance R égale à $Qc/C2\,\pi\,fo$ où Qc est le coefficient de surtension du condensateur C.

La méthode d'optimisation est une méthode itérative; à chaque itération, un problème non linéaire à résoudre est remplacé par une approximation linéaire. Lorsque la précision demandée est atteinte on arrête l'itération. On optimise encore les résultats en ajustant les couplages obtenus en fonction de la fréquence. Le choix d'un nombre impair de résonateurs permet d'obtenir plus facilement, pour une courbe d'amplitude donnée, la correction de la courbe de temps de propagation de groupe. Dans les deux premières réalisations on a cherché à avoir principalement une autocorrection du temps de propagation de groupe, et une symétrie arithmétique de l'amplitude autour de la fréquence centrale sans se préoccuper de l'atténuation de l'amplitude hors bande. On obtient une courbe d'amplitude présentant un minimum d'ondulation. Cette courbe présente également une symétrie arithmétique par rapport à la fréquence centrale Fo. On obtient ainsi également une symétrie arithmétique de la courbe de temps de propagation de groupe.

Pour l'exemple décrit, les résultats obtenus sont les suivants:

$$M1,2 = M4,5 = 0,597 \text{ pF}$$
$$M2,3 = M3,4 = 13\,417 \text{ nH}$$
$$M1,4 = 0,09 \text{ pF}$$
$$M2,5 = 0,09 \text{ pF}$$
$$C1 = C5 = 34,135 \text{ pF}$$
$$C2 = C4 = 39,555 \text{ pF}$$
$$C3 = 40,535 \text{ pF}$$
$$L1 = L2 = \ldots = L5 = 130 \text{ nH}.$$

La courbe d'amplitude A du filtre est représentée sur la figure 3. En abscisse sont portées les valeurs des fréquences en MHz. En ordonnées sont portées les atténuations d'amplitude (ou gain) en décibel. La symétrie arithmétique du filtre est traduite par une symétrie de la courbe par rapport à la fréquence centrale. Il y a symétrie arithmétique jusqu'à 25 dB de réjection hors bande. Ce qui signifie qu'il a encore une symétrie audelà des fréquences de coupures pour une atténuation de 25 dB. Cette courbe d'atténuation posséde des pentes raides ayant sensiblement la même allure aux deux fréquences de coupure. Ceci est dûe aux caractéristiques de symétrie arithmétique du filtre.

La courbe de temps de propagation de groupe T est représentée également sur la figure 3. En abscisse sont portées les fréquences en MHz. En ordonnées sont portés les temps en nano secondes. On constate que la courbe du temps de propagation de groupe a la même caractéristique que la courbe d'atténuation, à savoir, la symétrie arithmétique. On constate de plus, qu'il n'y a pratiquement pas de variation du temps de propagation entre 69,4 MHz et 70,5 MHz. La différence entre 69,4 MHz et 70,5 MHz représente à peu près les 80 pour cent de la bande utile du filtre. Il y a par conséquent une très bonne correction de variation de temps de propagation de groupe dans les 80 pour cent de la bande utile.

La description suivante se référe au schéma de principe de la figure 1, et au schéma de réalisation de la figure 6. Dans cette deuxième réalisation représentée sur la figure 6, le nombre de résonateur est identique à celui de la première réalisation. Les conditions d'alimentation et de charge sont les mêmes que dans la première réalisation. Les adaptateurs d'impédance 2.1 et 2.2 sont des condensateurs CE et CS. Ces condensateurs CE et CS sont égaux à 5,18 pF compte tenu des moyens de génération du signal.

Tous les couplages adjacents, c'est-à-dire M1,2, M2,3, M3,4, M4,5 sont capacitifs. Tous les couplages non adjacents c'est-à-dire M1,4 et M2,5 sont également capacitifs. D'autre part on a les relations et les résultats suivants:

$$M1,2 = M4,5 = 0,597 \text{ pF}$$
$$M2,3 = M3,4 = 0,385 \text{ pF}$$
$$M1,4 = 0,09 \text{ pF}$$
$$M2,5 = 0,09 \text{ pF}$$

$$C1 = C5 = 34,135 \text{ pF}$$
$$C2 = C4 = 38,783 \text{ pF}$$
$$C3 = 38,995 \text{ pF}$$
$$L1 = L2 = \ldots = L5 = 130 \text{ nH}.$$

Les résultats sont obtenus pour une fréquence centrale sensiblement égale à 70 MHz et une bande passante à peu près égale à 1,25 MHz.

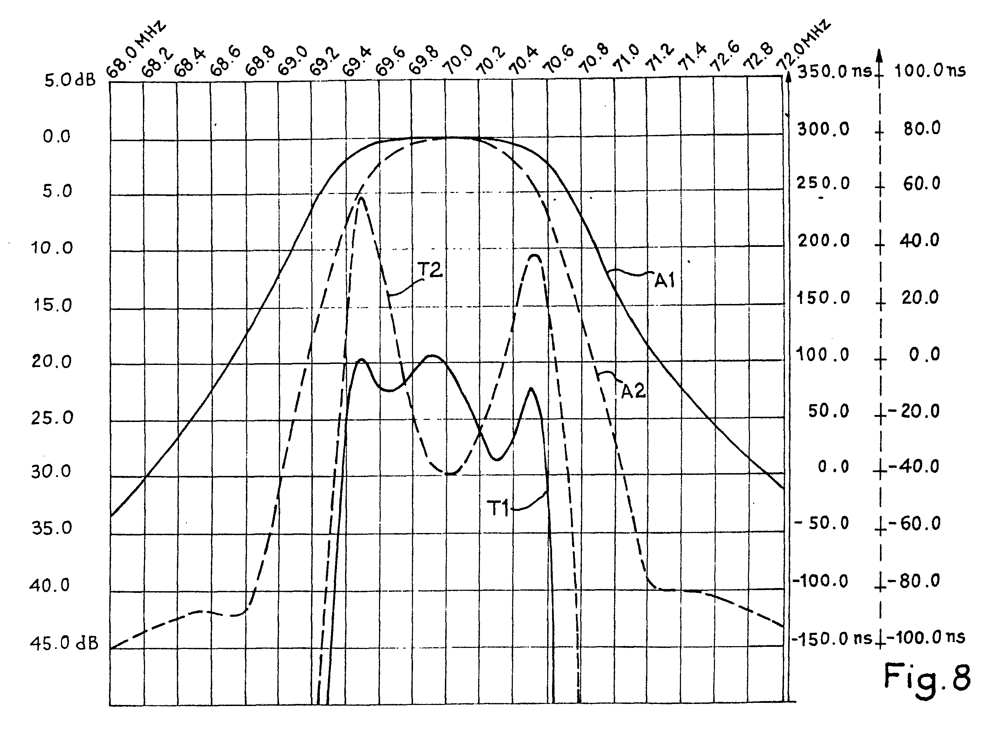

La courbe d'amplitude A1 obtenue pour cette deuxième réalisation est représentée sur la figure 8. Elle est identique à la courbe d'amplitude A de la première réalisation qui est représentée sur la figure 3.

La courbe de temps de propagation de groupe T1 est légèrement modifiée entre la fréquence de 70 MHz et la fréquence 70,5 MHz. Les variations du temps de propagation de groupe sont représentées sur l'axe des ordonnées qui figure en trait pointillé sur la figure 8. On constate que la variation du temps de groupe est plus grande pour cette deuxième réalisation dans cette zone de fréquence, que dans la première réalisation suivant la figure 2, l'autocorrection du temps de propagation de groupe est moins bonne. Malgré tout cette deuxième réalisation reste dans le gabarit du filtre idéal fixé pour les équations d'optimisation.

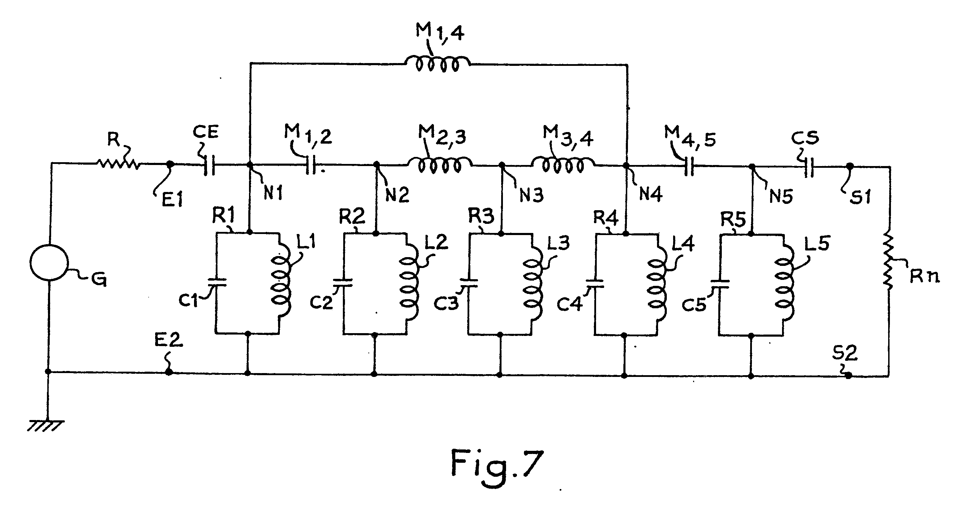

La description suivante se référe au schéma de principe de la figure 1, et au schéma de réalisation de la figure 7.

Les conditions d'alimentation et de charge sont les mêmes que dans les deux premières réalisations.

Les adaptateurs d'impédance CE et CS sont inchangés et restent égaux à 5,18 pF.

Les couplages adjacents M1,2 et M4,5 sont capacitifs. Les couplages adjacents M2,3 et M3,4 sont auto-inductifs.

Un seul couplage non adjacent est utilisé dans cette troisième réalisation. Il relie le premier résonateur et le quatrième, ce couplage M1,4 est auto-inductif. D'autre part on a les relations et les résultats suivants:

$$M1,2 = M4,5 = 0,59 \text{ pF}$$
$$M2,3 = M3,4 = 13\,417 \text{ nH}$$
$$M1,4 = 1\,000\,000 \text{ nH}$$
$$C1 = C5 = 34,135 \text{ pF}$$
$$C2 = C4 = 39,555 \text{ pF}$$
$$C3 = 40,535 \text{ pF}$$
$$L1 = L2 = \ldots L5 = 130 \text{ nH}$$

Les résultats sont obtenus pour une fréquence centrale sensiblement égale à 70 MHz et une bande passante à peu près égale à 1,25 MHz. La courbe d'amplitude A2 obtenue pour cette troisième réalisation est également représentée sur la figure 8. Cette courbe d'amplitude A2 est légèrement différente des deux courbes d'amplitudes A et A1. La courbe A2 présente des atténuations très importantes au-delà des fréquences de coupures c'est-à-dire hors bande. Le filtre est par conséquent plus sélectif.

Sur la courbe de variation du temps de propagation de groupe T2 représentée sur la figure 8, on constate des variations plus importantes du temps de propagation. Les variations de temps de propagation de groupe sont représentées sur l'axe des ordonnées qui figure en trait plein sur la figure 8.

La première et la troisième réalisation montrent l'indépendance de la correction de la variation du temps de propagation de groupe, et de la correction d'amplitude. La deuxième réalisation n'est qu'une variante de la première réalisation.

Les trois réalisations décrites ont subi un test de variation de température. Les essais ont été effectués entre une température minimale sensiblement égale à −30°C, et une température maximale sensiblement égale à +70°C. Après ces essais les courbes d'amplitude et de temps de propagation de groupe subissent des variations négligeables, et restent très près de la réponse idéale du filtre.

Les résultats obtenus sont identiques à ceux que l'on obtient en utilisant des filtres plus des correcteurs, mais l'encombrement est réduit de plus de 50%, et de plus aucun problème d'instabilité dû à la température ne s'est posé en raison de l'absence d'élément actif.

**Revendications**

1. Filtre électrique autocorrigé d'ordre impair à éléments à constantes localisées, comportant des premiers moyens d'adaptation d'entrée (2.1) pour recevoir le signal d'entrée, l'adapter et le transmettre à des moyens de filtrage (3) constitués par un ensemble de n résonateurs (R1, R2, ... Rn) en nombre impair et en cascade pour filtrer le signal en large bande et le transmettre à des deuxièmes moyens d'adaptation de sortie (2.2), et comportant des moyens de corrections (4) constitués par un premier ensemble de moyens de couplage adjacent Mi,j; chaque moyen (Mi,j) reliant deux résonaterus adjacents i et j, i étant égal à 1, 2 ... (n−1), j étant égal à i+1, caractérisé en ce que les moyens de correction (4) comprennent également un deuxième ensemble de moyens de couplage non adjacent Mk,l, chaque moyen (Mk,l) reliant un k$^{\text{ième}}$ et un l$^{\text{ième}}$ résonateur k, étant égal à 1, 2, 3 ... (n−3) et l étant égal à k+3, pour obtenir une symétrie arithmétique des courbes d'amplitude (A) et de temps de propagation de groupe (T), et corriger les distorsions du temps de propagation de groupe.

2. Filtre électrique autocorrigé d'ordre impair selon la revendication 1, pourvu d'une première (E1) et d'une deuxième (E2) entrée, caractérisé en ce qu'il comporte un premier condensateur d'adaptation (CE) à la première entrée (E1) du filtre, cinq résonateurs en cascade dont un premier est connecté d'une part à un premier nœud (N1), d'autre part à la deuxième entrée E2, chaque résonateur étant constitué par un condensateur (C1) en parallèle sur une inductance (L1); en ce qu'il comporte: un premier (M1,2) condensateur connecté entre le premier (R1) et le deuxième (R2) résonateur, une première (M2,3) et une deuxième (M3,4) inductance connectées respectivement entre le deuxième (R2) et le troisième (R3) résonateur, le troisième (R3) et le quatrième (R4) résonateur un deuxième condensateur (M4,5) connecté entre le quatrième (R4) et le cinquième (R5) résonateur; et en ce qu'il comporte un troisième (M1,4) et un quatrième (M2,5) condensateur connectés respectivement entre le premier (R1) et le quatrième (R4) résonateur, le deuxième (R2) et cinquième (R5) résonateur afin de réaliser une autocorrection du temps de propagation de groupe.

3. Filtre électrique autocorrigé d'ordre impair selon la revendication 1, pourvu d'une première entrée (E1) et d'une deuxième entrée (E2), caractérisé en ce qu'il comporte un premier condensateur d'adaptation (CE) à la première entrée (E1) du filtre, cinq résonateurs en cascade dont un premier est connecté d'une part à un premier nœud (N1) d'autre part à l'entrée E2, chaque résonateur étant constitué par un condensateur (C1) en parallèle sur une inductance (L1); en ce qu'il comporte un premier (M1,2) condensateur connecté entre le premier (R1) et le deuxième (R2) résonateur, une première (M2,3) et une deuxième (M3,4) inductance connectées respectivement entre le deuxième (R2) et le troisième (R3) résonateur, et le troisième (R3) et le quatrième (R4) résonateur, un deuxième condensateur (M4,5) connecté entre le quatrième (R4) et le cinquième (R5) résonateur; et en ce qu'il comporte une troisième (M1,4) inductance connectée entre le premier (R1) et le quatrième (R4) résonateur afin de réaliser une correction de l'amplitude.

**Patentansprüche**

1. Elektrisches selbstkorrigiertes Filter ungerader Ordnung mit lokalisierte Kontanten aufweisenden Elementen, versehen mit ersten Mitteln zur Eingangsanpassung (2.1) für den Empfang des Eingangssignals, Anpassung und Übertragung desselben zu Filtermitteln (3), die durch eine Gruppe von n Resonatoren (R1, R2, ... Rn) gebildet sind, deren Anzahl ungerade ist und die in Kaskade liegen, um das Signal breitbandig zu filtern und es zweiten Mitteln zur Ausgangsanpassung (2.2) zuzuführen, und versehen mit Korrekturmitteln (4), die durch eine erste Gruppe von Nebenkopplungsmitteln Mi,j gebildet sind; wobei jedes Mittel (Mi,j) zwei benachbarte Resonatoren i und j verbindet, worin i gleich 1, 2 ... (n−1) und j gleich i+1 ist, dadurch gekennzeichnet, daß die Korrekturmittel (4) ferner eine zweite Gruppe von Nicht-Nebenkopplungsmitteln Mk,l umfassen, wovon jedes Mittel (Mk,l) einen k-ten mit einem l-ten Resonator verbindet, worin k gleich 1, 2, 3 ... (n−3) und l gleich k+3 ist, um eine arithmetische Symmetrie der Amplitudenkurven (A) und der Gruppenlaufzeitkurven (T) zu erhalten und die Verzerrungen der Gruppenlaufzeit zu korrigieren.

2. Elektrisches selbstkorrigiertes Filter ungerader Ordnung nach Anspruch 1, versehen mit einem ersten (E1) und einem zweiten (E2) Eingang, dadurch gekennzeichnet, daß es einen ersten Anpassungskondensator (CE) zur Anpassung an den ersten Eingang (E1) des Filters, fünf in Kaskade liegende Resonatoren, wovon der erste einerseits mit einem ersten Knotenpunkt (N1) und andererseits mit dem zweiten Eingang E2 verbunden ist, wobei jeder Resonator durch einen Kondensator (C1) parallel mit einer Induktivität (L1) gebildet ist; daß es enthält: einen ersten Kondensator (M1,2), der zwischen den ersten (R1) und den zweiten (R2) Resonator geschaltet ist, eine erste (M2,3) und eine zweite (M3,4) Induktivität, die zwischen den zweiten (R2) und den dritten (R3) Resonator bzw. dritten (R3) und vierten (R4) Resonator geschaltet sind, einen zweiten Kondensator (M4,5), der zwischen den vierten (R4) und den fünften (R5) Resonator geschaltet ist; und daß es einen dritten (M1,4) und einen fünften (M2,5) Kondensator enthält, die zwischen den ersten (R1) und den vierten (R4) Resonator bzw. zwischen den zweiten (R2) und den fünften (R5) Resonator geschaltet sind, um eine Selbstkorrektur der Gruppenlaufzeit zu erreichen.

3. Elektrisches selbstkorrigiertes Filter ungerader Ordnung nach Anspruch 1, versehen mit einem ersten Eingang (E1) und einem zweiten Eingang (E2), dadurch gekennzeichnet, daß es einen ersten Kondensator (CE) zur Anpassung an den ersten Eingang (E1) des Filters und fünf in Kaskade liegende Resonatoren enthält, wovon ein erster einerseits mit einem ersten Knotenpunkt (N1) und andererseits mit dem Eingang E2 verbunden ist, wobei jeder Resonator aus einem Kondensator (C1) parallel mit einer Induktivität (L1) gebildet ist; daß es einen ersten Kondensator (M1,2), der zwischen den ersten (R1) und den zweiten (R2) Resonator geschaltet ist, eine erste (M2,3) und eine dritte (M3,4) Induktivität enthält, die zwischen den zweiten (R2) und den dritten (R3) Resonator bzw. zwischen den dritten (R3) und den vierten (R4) Resonator geschaltet sind, und einen zweiten Kondensator (M4,5), der zwischen den vierten (R4) und den fünften (R5) Resonator geschaltet ist; und daß es eine dritte (M1,4) Induktivität enthält, welche zwischen den ersten (R1) und den vierten (R4) Resonator geschaltet ist, um eine Amplitudenkorrektur zu erhalten.

**Claims**

1. Electric self-correcting filter of odd order and with localised constant elements, comprising first input adaptation means (2.1) for receiving the input signal, adapting and transmitting the same to filter means (3) formed of a set of n resonators (R1, R2, ... Rn) of odd number and connected in cascade for wide band filtering of the signal and transmission thereof to second output adaptation means (2.2), and comprising correction means (4) formed of a first set of adjacent coupling means Mi,j; each means (Mi,j) connecting two adjacent resonators i and j, i being equal to 1, 2 ... (n−1), j being equal to i+1, characterized in that the correction means (4) further comprise a second set of non-adjacent coupling means Mk,l, each means (Mk,l) connecting a $k^{th}$ and a $l^{th}$ resonator, k being equal to 1, 2, 3 ... (n−3) and l being equal to k+3, for obtaining an arithmetical symmetry of the amplitude (A) and group delay (T) curves and correcting the distortions of the group delay.

2. Electric self-correcting filter of odd order according to claim 1, provided with a first (E1) and a second (E2) input, characterized in that it comprises a first adaptation capacitor (CE) at the first input (E1) of the filter, five cascade connected resonators the first of which is connected to a first nod (N1) on the one hand and to a second input E2 on the other hand, each resonator being formed of a capacitor (C1) connected in parallel with an inductance (L1); that it comprises: a first (M1,2) capacitor connected between the first (R1) and the second (R2) resonators, a first (M2,3) and a second (M3,4) inductance respectively connected between the second (R2) and the third (R3) resonators and between the third (R3) and the fourth (R4) resonators, a second capacitor (M4,5) connected between the fourth (R4) and the fifth (R5) resonators; and in that it comprises a third (M1,4) and a fourth (M2,5) capacitor respectively connected between the first (R1) and the fourth (R4) resonators and between the second (R2) and the fifth (R5) resonators, in order to obtain a self-correction of the group delay.

3. Electric self-correcting filter of odd order according to claim 1, provided with a first (E1) and a second (E2) input, characterized in that it comprises a first capacitor (CE) for adaptation to the first input (E1) of the filter, five cascade connected resonators the first of which is connected to a first nod (N1) on the one hand and to the input E2 on the other hand, each resonator being formed of a capacitor (C1) connected in parallel with an inductance (L1); that it comprises a first (M1,2) capacitor connected between the first (R1) and the second (R2) resonators, a first (M2,3) and a second (M3,4) inductance respectively connected between the second (R2) and the third (R3) resonators and between the third (R3) and the fourth (R4) resonators, and a second capacitor (M4,5) connected between the fourth (R4) and the fifth (R5) resonators, and in that it comprises a third (M1,4) inductance connected between the first (R1) and the fourth (R4) resonators for obtaining an amplitude correction.

M 4,7

Mn-6,n-3

M 3,6

Mn-5,n-2

M 2,5

Mn-4,n-1

M 1,4

Mn-3,n

4

4.5

| M 1,2 | M 2,3 | M 3,4 | M 4,5 | M 5,6 | M 6,7 | M 7,8 | M 8,9 | Mn-2,n-1 | Mn-1,n |

4.6

6

E1
E2

S1
S2

R1   R2   R3   R4   R5   R6   R7   R8   R9   R10   Rn

2.1

2.2   1.2

1.1

3

Fig.1

0 061 950

1S

1E

2E

2S

Fig.4

N

Fig.5

Fig.2

0 061 950

0 061 950

Fig. 3

13

Fig.6

Fig.7

Fig. 8